# EUROPEAN PATENT APPLICATION

(11) **EP 2 405 731 A2**
(43) Date of publication of application: **11.01.2012**
(21) Application number: 11165178.2
(22) Date of filing: 06.05.2011
(51) Int. Cl.: H05K 9/00

(54) **Module and portable terminal**

(30) Priority: 08.07.2010 JP 2010155903
(71) Applicant: Sony Corporation, Tokyo 108-0075 (JP)
(72) Inventor: Tsukamoto, Sotaro, Minato-ku Tokyo 108-0075 (JP); Inagaki, Eigo, Minato-ku Tokyo 108-0075 (JP)
(74) Representative: Turner, James Arthur

(57) **Abstract**

A module includes a circuit board; electronic components mounted on the circuit board; a mold resin that insulates and seals the electronic components; a shield conducting film that covers the outside of the mold resin; and shield conducting walls which are so formed in the mold resin as to divide the mold resin into a plurality of regions.

## Description

This invention relates to modules and portable terminals.

Any module in which small electronic components mounted on a circuit board constitute circuits usually has its circuits electromagnetically shielded so as to prevent them from interfering with one another in the module or with actions of other electronic machines or from adversely affecting human bodies. In addition, it is common practice to electromagnetically shield those circuits vulnerable to electromagnetic interference so as to provide them with electromagnetic resistance.

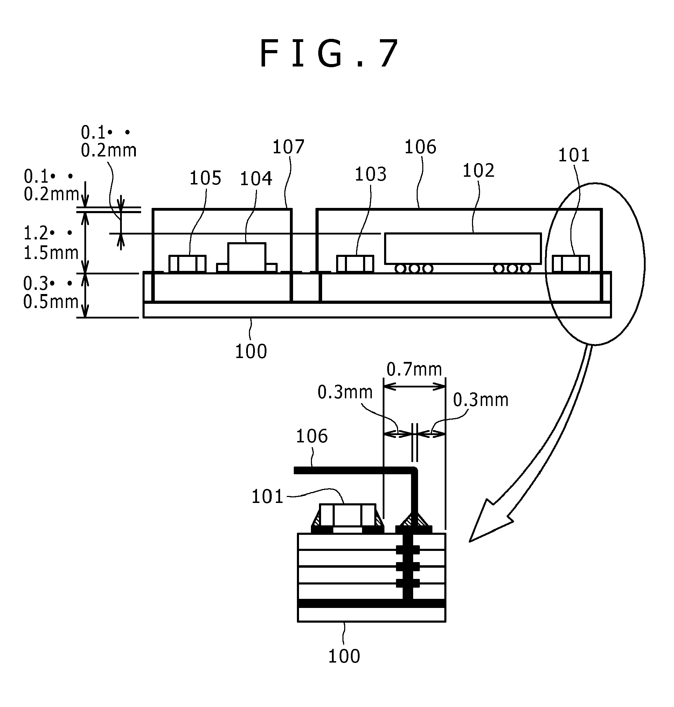

Fig. 7 of the accompanying drawings is a diagram illustrating one example of the method for electromagnetic shielding with shield caps on the module.

There are shown a circuit board 100 and electronic components 101, 102, 103, 104, and 105 mounted thereon. The electronic components 101, 102, and 103 are covered with a metal shield cap 106, and the electronic components 104 and 105 are also covered with a metal shield cap 107, both intended for EMC (electromagnetic compatibility). The shield caps 106 and 107 are connected to the ground pads formed on the surface of the circuit board 100, and the ground pads are electrically connected (or grounded) through via through holes to the solid plane ground as an inner layer on the circuit board 100.

The foregoing arrangement needs means for preventing the shield caps 106 and 107 from interfering with the electronic components 101, 102, 103, 104, and 105 mounted on the circuit board 100 on account of their dimensional variation and their erroneous mounting alignment. For this reason it is necessary that the shield caps and electronic components should be positioned sufficiently apart and the shield caps should be sufficiently higher than the electronic components.

To be more specific, there should be a gap of at least 0.3 mm between the shield cap 106 and the end (or land) of the electronic component 101. Also, there should be a gap of at least 0.3 mm between the shield cap 106 and the end of the circuit board 100. This means that the end (or the end of the land) of the electronic component 101 should be at least 0.7 mm away from the end of the circuit board 100 if the shield cap 106 has a thickness of 0.1 to 0.2 mm.

In addition, there should be an air gap of about 0.1 to 0.2 mm in the vertical direction from the top of the electronic component 102 (which is highest) to the shield cap 106. Therefore, the distance from the circuit board 100 to the shield cap 106 should be 1.2 to 1.5 mm. It follows that the module would have a height of about 1.6 to 2.2 mm if the circuit board 100 has a thickness of 0.3 to 0.5 mm and the shield cap 106 has a thickness of 0.1 to 0.2 mm.

Electromagnetic shielding with the shield caps 106 and 107 needs a large area for their mounting as well as a sufficient upward space; therefore, it hinders the size reduction and height reduction of the module.

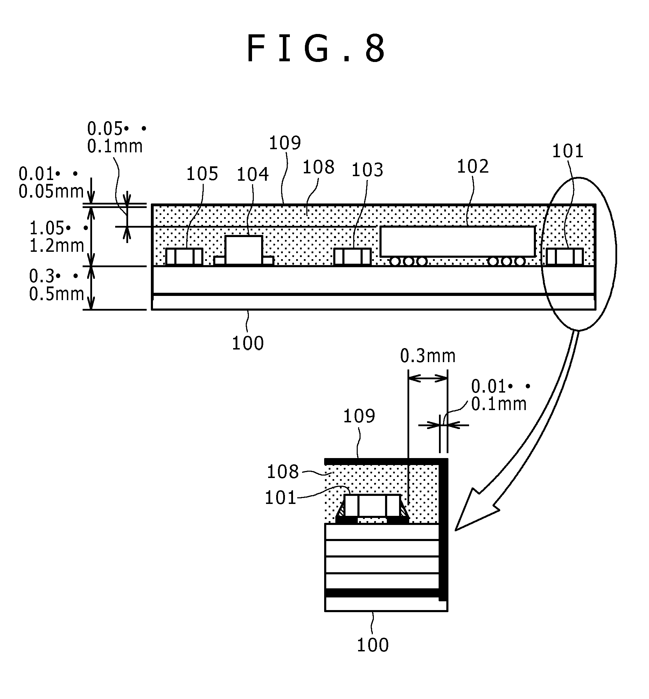

Fig. 8 of the accompanying drawings is a diagram illustrating one example of the method for electromagnetic shielding of a resin-sealed module with shield coating. The constituents in Fig. 8 which are identical with or equivalent to those in Fig. 7 are given the same reference numbers without repetition of their detailed description.

The electromagnetic shielding method mentioned above employs a mold resin 108 (for sealing) and a shield conducting film 109 (of conductive paint) applied to the outside of the resin by coating or printing. It saves the area and height for mounting, thereby achieving the size reduction and height reduction of the module. (See Japanese Patent Laid-open No. 2005-79139 and Japanese Patent Laid-open No. 2008-288610, for example.)

The module shielded in this manner has a minimum gap of 0.3 mm between the end of the circuit board 100 and the end (or the end of the land) of the electronic component 101. It also has the shield conducting film 109 having a thickness of 0.01 to 0.1 mm, which is electrically connected to the solid plane ground as an internal layer on the circuit board 100. There is a gap of 0.05 to 0.1 mm between the shield conducting film 109 and the top of the highest electronic component 102. The shield conducting film 109 has a thickness of 0.01 to 0.05 mm above the top of the mold resin 108. The mold resin 108 has a thickness of 1.05 to 1.2 mm between the circuit board 100 and the shield conducting film 109. The circuit board 100 has a thickness of 0.3 to 0.5 mm. Consequently, the module height is limited to about 1.36 to 1.75 mm.

The module sealed with the mold resin 108 and covered with the shield conducting film 109 by coating or printing offers the advantage of saving the mounting area and reducing the height and increasing the strength.

Although the foregoing technology is capable of reducing the size and height of the module by sealing electronic components with a resin and covering the seal resin with a shield conducting material, it involves difficulties in shielding circuit blocks individually on the circuit board. The reason for this is that the resin molding process is carried out while the circuit board is not yet separated into individual modules but is a collection of sub-boards. The molding process carried out in such a state leads to the deterioration of characteristic properties due to cross talk between circuit blocks and EMC noise if there are a plurality of circuit blocks in the module.

The present disclosure was completed in view of the foregoing. There is a need for the present disclosure to provide a module which permits the electronic components sealed with a mold resin to be shielded for individually divided circuit blocks.

Various respective aspects and features of the invention are defined in the appended claims. Combinations of features from the dependent claims may be combined with features of the independent claims as appropriate and not merely as explicitly set out in the claims.

Embodiments of the present invention relate to a module including a circuit board and electronic components (such as integrated circuits and passive elements) mounted thereon, and also to a portable terminal equipped with the module.

An embodiment of the present disclosure provides a module which includes a circuit board, electronic components mounted on the circuit board, a mold resin that insulates and seals the electronic components, a shield conducting film that covers the outside of the mold resin, and shield conducting walls which are so formed in the mold resin as to divide the mold resin into a plurality of regions.

The module constructed as mentioned above permits the shield conducting walls formed in the mold resin to shield the circuit blocks each including of electronic components mounted on the circuit board.

With the module constructed as mentioned above, it is possible to shield the circuit blocks in small units without adverse effects on the module with mold resin sealing and shield coating which has the advantage of being small in size and low in height. Thus the module protects its characteristics from deterioration by crosstalk between circuit blocks and EMC radiation noise.

Embodiments of the invention will now be described with reference to the accompanying drawings, throughout which like parts are referred to by like references, and in which:
Figs. 1A and 1B are diagrams illustrating the structure of the module pertaining to a first embodiment of the disclosure, Fig. 1A is a schematic sectional view of the module, and Fig. 1B is a schematic plan view of the module;
Figs. 2A and 2B are diagrams illustrating the detailed structure (in side view) of the module pertaining to the first embodiment of the disclosure, Fig. 2A is a partial sectional view illustrating the structure (in side view) of the module, and Fig. 2B is a partial sectional view illustrating the structure (in side view) of the module in its modified form;
Figs. 3A and 3B are diagrams illustrating the structure of the module pertaining to a second embodiment of the disclosure, Fig. 3A is a schematic sectional view of the module, and Fig. 3B is a schematic plan view of the module;
Figs. 4A and 4B are diagrams illustrating the structure of the module pertaining to a third embodiment of the disclosure, Fig. 4A is a schematic sectional view of the module, and Fig. 4B is a schematic plan view of the module;
Fig. 5 is a block diagram showing an example of the structure of the RF module for a portable terminal;
Fig. 6 is a schematic diagram showing a portable terminal equipped with the module;
Fig. 7 is a diagram showing an example of the method for electromagnetic shielding of the module with shield caps; and
Fig. 8 is a diagram showing an example of the method for electromagnetic shielding of the resin-sealed module with shield coating.

The embodiments of the present disclosure will be described in more detail with reference to the accompanying drawings.

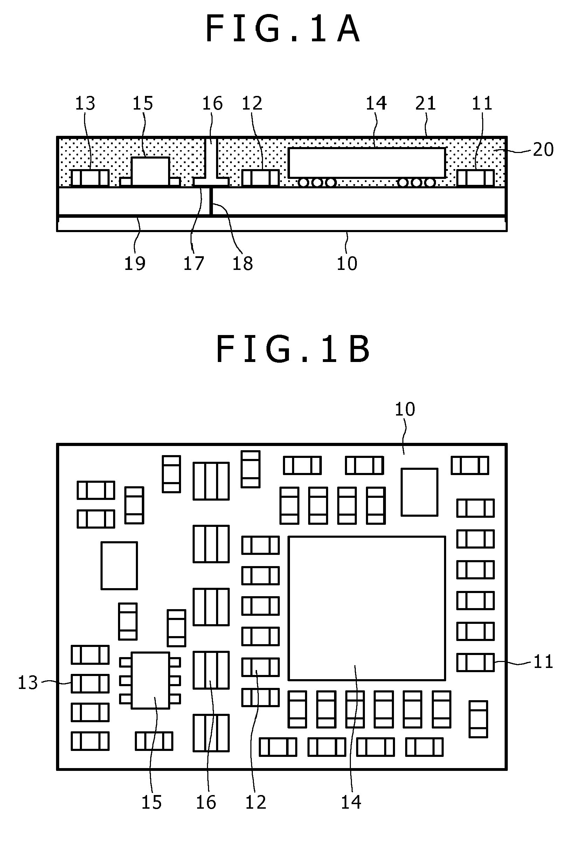

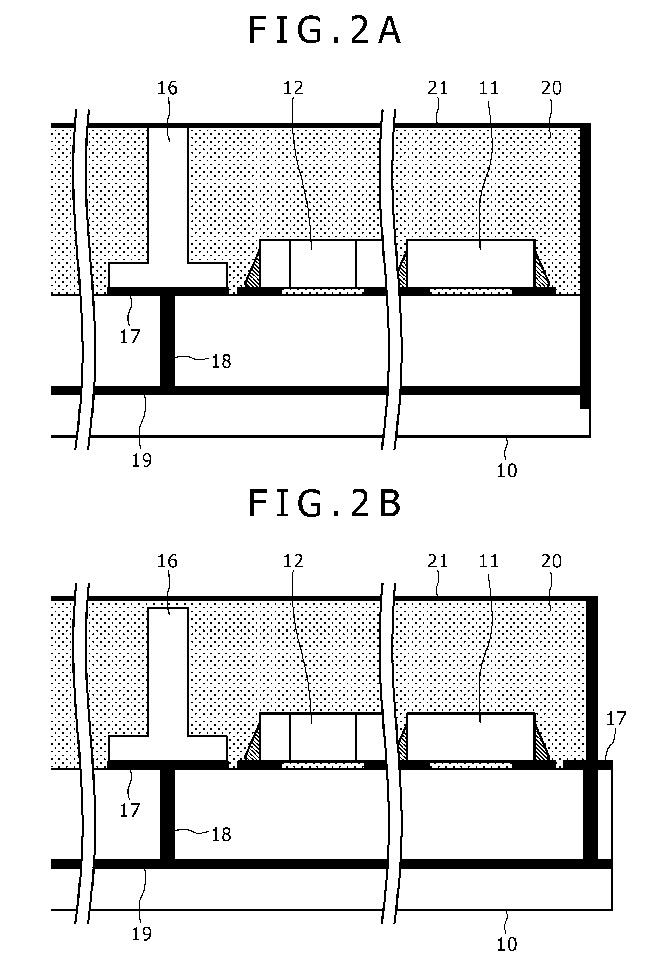

Figs. 1A and 1B are diagrams illustrating the structure of the module pertaining to a first embodiment of the disclosure. Fig. 1A is a schematic sectional view of the module. Fig. 1B is a schematic plan view of the module. Figs. 2A and 2B are diagrams illustrating the detailed structure (in side view) of the module pertaining to the first embodiment of the disclosure. Fig. 2A is a partial sectional view illustrating the structure (in side view) of the module. Fig. 2B is a partial sectional view illustrating the structure (in side view) of the module in its modified form.

The module pertaining to the first embodiment includes of a circuit board 10 and a plurality of electronic components 11, 12, 13, 14, and 15 mounted thereon. The electronic components 11, 12, and 13 include transistor, diode, resistor, capacitor, inductor, etc. of surface mount type. The electronic components 14 and 15 are integrated circuits. On the circuit board 10 is mounted a conducting part 16 of metal. Incidentally, the circuit board 10 may be a plastic board of glass epoxy or a ceramic board of LTCC (Low Temperature Co-fired Ceramics), alumina, or aluminum nitride.

The conducting part 16 is mounted on a ground pad 17 formed on the surface of the circuit board 10, as shown in Fig. 1A. This ground pad 17 is electrically connected to a solid plane ground 19 (which is an internal layer on the circuit board 10) through a via through hole 18. There are several of the conducting part 16 arranged and mounted on the top surface of the circuit board 10, as shown in Fig. 1B. Thus, they form the conducting shield wall that electromagnetically shields the region of the circuit block containing the electronic parts 11, 12, and 14, and the region of the circuit block containing the electronic parts 13 and 15. Incidentally, the module pertaining to the first embodiment employs several pieces of the small conducting part 16 arranged at a certain pitch as the shield conducting wall. This design assumes the use of a general-purpose surface mounter for small-sized electronic parts. However, it may be so modified as to replace several pieces (five pieces in Fig. 1B) by a single piece if there is available a surface mounter capable of mounting large-sized electronic parts.

The electronic parts 11 to 15 and the conducting part 16, which are mounted on the circuit board 10, are sealed with an insulating mold resin 20 such as epoxy resin, and the surface of the mold resin 20 is coated with a shield conducting film 21. Resin sealing is accomplished by flowing the mold resin 20 over the circuit board 10 (in the form of an aggregate of individual circuit boards) on which are mounted the electronic parts 11 to 15 and the conducting part 16 constituting each module. Coating with the shield conducting film 21 is accomplished by printing with a conductive paste (such as silver paste) or by spraying with a conductive paint (such as silver paint, copper paint, and copper-silver paint).

Coating with the shield conducting film 21 is preceded by forming a half-cut groove (reaching the ground pattern on the circuit board 10) in the mold resin 20 with the help of a wide dicing saw moving along the cut line to separate the large circuit board into individual small circuit boards. Coating in this way forms the shield conducting film 21 on the top of the mold resin 20 and on the inner wall of the half-cut groove. The shield conducting film 21 formed on the inner wall of the half-cut groove serves as the conducting film on the side of the mold resin 20 after the large circuit board has been cut into small circuit boards for individual modules. Incidentally, the conducting part 16 will come into electrical contact with the shield conducting film 21 after coating if it is high enough to expose itself from the top of the mold resin 20.

The shield conducting film 21 (which is formed on the side of the mold resin 20) conducts to the ground of the circuit board 10 at a different position depending on the depth of the half-cut groove. In the case shown in Fig. 2A, the half-cut groove is so formed as to reach the solid plane ground 19 as an inner layer on the circuit board 10, so that the shield conducting film 21 conducts to the solid plane ground 19. Likewise, in the case shown in Fig. 2B, the half-cut groove is so formed as to reach the ground pad 17, so that the shield conducting film 21 conducts to the ground pad 17.

The large circuit board is completely cut and separated into small circuit boards for individual modules by means of a narrow dicing saw after the mold resin 20 has been coated with the shield conducting film 21 and the half-cut groove has been filled with the conductive paste. Incidentally, the shield conducting film 21 on the side of the mold resin 20 may also be formed by printing with a conductive paste after cutting into small circuit boards, or by spraying with a conducting paint, with the bottom of the module masked, after cutting into small circuit boards.

The module pertaining to the first embodiment of the present disclosure can be produced in substantially the same way as the existing one except for the additional step of mounting the conducting part 16 on the circuit board 10. According to the fabricating method employed in the embodiment, the shield conducting wall is formed as the conducting part 16 (in several pieces) is mounted on the circuit board 10. Therefore, the shield conducting wall may be formed in any pattern on the circuit board 10 by properly arranging the conducting part 16. For example, the pattern may include L-shape, T-shape, π-shape, and cross-shape. In addition, they may be arranged straight or zigzag (to get out densely mounted electronic parts), continuously or intermittently.

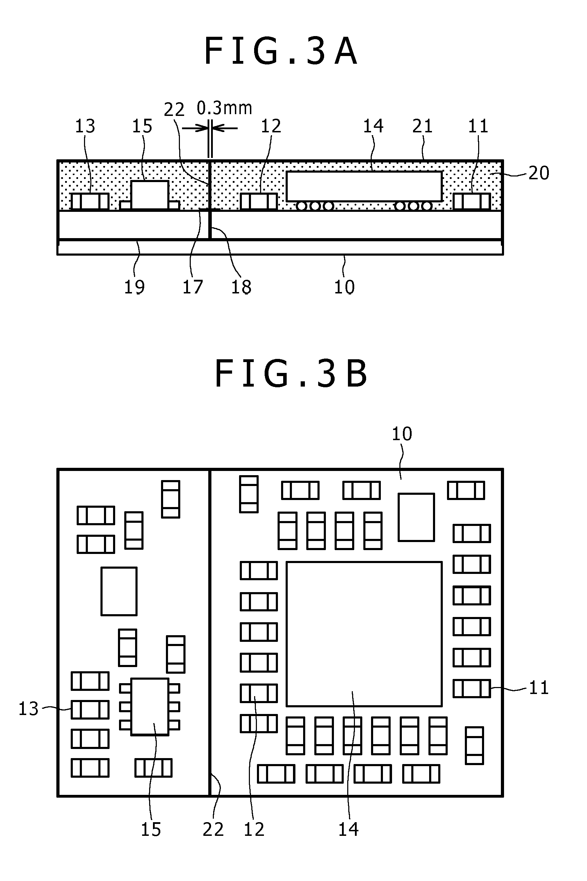

Figs. 3A and 3B are diagrams illustrating the structure of the module pertaining to a second embodiment of the disclosure. Fig. 3A is a schematic sectional view of the module. Fig. 3B is a schematic plan view of the module. The constituents in Figs. 3A and 3B which are identical with or equivalent to those in Figs. 1A and 1B are given the same reference numbers without repetition of their detailed description.

The module pertaining to the second embodiment has the shield conducting wall which is formed by the same method (coating) as shown in Fig. 2B. That is, the half-cut groove reaching the ground pad 17 on the circuit board 10 is formed by means of a dicing saw at a prescribed position of the mold resin 20. Then, the half-cut groove is filled with a conductive paste or paint to form a shield conducting wall 22. The resulting shield conducting wall 22 conducts to the shield conducting film 21 formed thereon. The filling of the half-cut groove with a conductive paste or paint may be accomplished in the same way as that for covering the top of the mold resin 20 with the shield conducting film 21, so that the shield conducting wall 22 is formed integrally with the shield conducting film 21.

In the case where it is difficult to completely fill the half-cut groove (down to the ground pad 17) with a conductive paste or paint that forms the shield conducting film 21 on the mold outer surface, it is necessary to form the shield conducting wall 22 before the shield conducting film 21 is formed. To this end, it is desirable to properly select the slit width of the half-cut groove and the viscosity of the conductive paint to be used for filling. For example, if the slit width of the half-cut groove is 0.3 mm, the conductive paint should have a viscosity of about 25 to 40 Pa/s and should optionally be defoamed by evacuation.

The module pertaining to the second embodiment may have the shield conducting wall 22 formed straight or crosswise (across the module) as shown in Figs. 3A and 3B. However, it should not have the half-cut groove formed in L-shape, T-shape, or π-shape because the dicing saw to make the half-cut groove is circular and the half-cut groove in one module should be continuous with the one in the adjoining module.

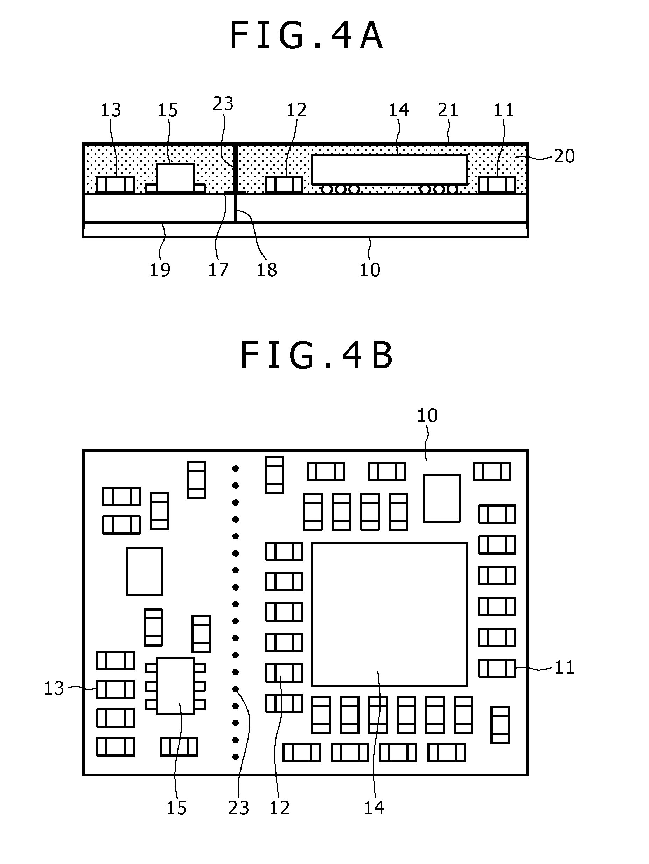

Figs. 4A and 4B are diagrams illustrating the structure of the module pertaining to a third embodiment of the disclosure. Fig. 4A is a schematic sectional view of the module. Fig. 4B is a schematic plan view of the module. The constituents in Figs. 4A and 4B which are identical with or equivalent to those in Figs. 3A and 3B are given the same reference numbers without repetition of their detailed description.

The module pertaining to the third embodiment has the shield conducting wall which includes of several pieces of conducting column 23 formed in the mold resin 20 at a prescribed pitch along the boundary separating the mold resin 20. The conducting column 23 is formed by filling a conductive paste into a non-through hole which has been made in the mold resin 20 by laser beam machining. Immediately under the non-through hole is the ground pad 17 on the circuit board 10. The ground pad 17 appreciably reflects the laser beam, so that the conducting column 23 reaches an adequate depth if the laser bean is properly controlled in its intensity. The laser beam machining in this manner permits the shield conducting wall to be formed in T-shape or π-shape. The conducting column 23 includes of a cylindrical non-through hole and a conductor filled therein, and hence it resembles a kind of blind via hole. Therefore, the resulting shield conducting wall is not continuous but is capable of preventing EMC leakage if the conducting columns 23 are arranged at proper intervals.

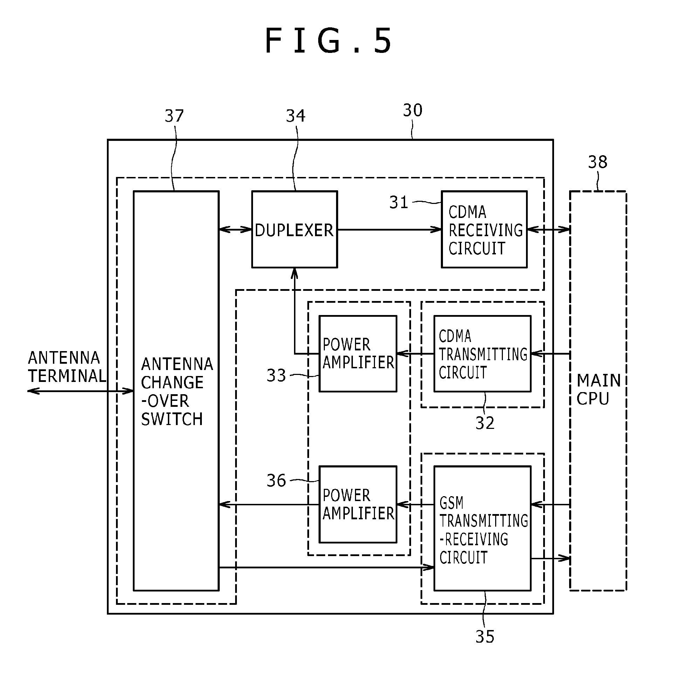

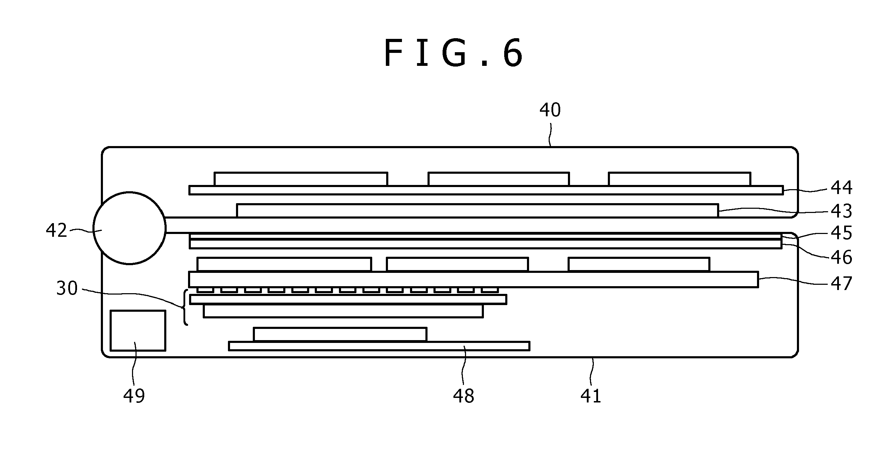

Fig. 5 is a block diagram showing an example of the structure of the RF module for a portable terminal. Fig. 6 is a schematic diagram showing a portable terminal equipped with the module.

The portable telephone as one of portable terminals is usually equipped with modules for different communication systems, and it is capable of switching them from one to another according to need. For example, an RF (high-frequency) module 30 for the portable telephone shown in Fig. 5 has a CDMA (Code Division Multiple Access) receiving circuit 31, a CDMA transmitting circuit 32, a power amplifier 33, and a duplexer 34. It also has a GSM (Global System for Mobile Communications) transmitting-receiving circuit 35 and a power amplifier 36. The duplex 34 and the power amplifier 36 are connected to an antenna change-over switch 37, which is connected to the antenna terminal. The CDMA receiving circuit 31, the CDMA transmitting circuit 32, and the GSM transmitting-receiving circuit 35 are connected to a main CPU (Central Processing Unit) 38 of the portable telephone.

The portable telephone may have the possibility of establishing electromagnetic shielding between the circuit block for the transmitting signal system and the circuit block for the receiving signal system, or establishing electromagnetic shielding between circuit blocks for individual communication systems, or establishing electromagnetic shielding between circuit blocks for individual frequency bands. The RF module 30 shown in Fig. 5 has the circuit block (containing the CDMA receiving circuit 31, the duplexer 34, and the antenna change-over switch 37) shielded by the shield conducting wall indicated by a broken line. This shield conducting wall is realized by any one of the shield conducting walls pertaining to the first to third embodiments mentioned above. The shield conducting wall is also provided for the circuit block for the CDMA transmitting circuit 32, the circuit block for the GSM transmitting-receiving circuit 35, and the circuit block containing the power amplifier 33 and the power amplifier 36.

An example of the RF module 30 mounted in a portable telephone is shown in Fig. 6. This portable telephone is made up of two enclosures 40 and 41 joined together by a hinge 42. One enclosure 40 holds a liquid crystal display 43 and a circuit board 44 for the liquid crystal display 43. The other enclosure 41 holds a keyboard 45, a reinforcing metal plate 46, a main circuit board 47, a sub-circuit board 48, and an antenna 49. The main circuit board 47 contains the main CPU 38, the main memory, the RF circuit, etc. In the main circuit board 47 is mounted the RF module 30 shown in Fig. 5.

The RF module 30 is constructed such that the mold resin 20 is divided by the shield conducting wall; therefore, it offers the advantage of being small in size and low in height as in the case of the module with mold resin sealing and shield coating. Moreover, the fact that the circuit block is shielded in small units is effective in preventing the characteristic properties from being deteriorated by crosstalk between circuit blocks and EMC radiation noise.

The present disclosure contains subject matter related to that disclosed in Japanese Priority Patent Application JP 2010-155903 filed in the Japan Patent Office on July 8, 2010.

It should be understood by those skilled in the art that various modifications, combinations, sub-combinations and alterations may occur depending on design requirements and other factors insofar as they are within the scope of the appended claims.

## Claims

1. A module, comprising:
a circuit board;
electronic components mounted on the circuit board;
a mold resin that insulates and seals the electronic components;
a shield conducting film that covers the outside of the mold resin; and
shield conducting walls which are so formed in the mold resin as to divide the mold resin into a plurality of regions.

2. The module as defined in claim 1, wherein the shield conducting wall is a metal part which is mounted on the circuit board and conducts to the ground.

3. The module as defined in claim 2, wherein the metal part is composed of a plurality of conductive pars arranged at a prescribed pitch.

4. The module as defined in claim 1, wherein the shield conducting wall is formed by filling a conductive paste or paint into a groove which has been formed in the mold resin in such a way that it separates the mold resin.

5. The module as defined in claim 4, wherein the shield conducting wall conducts to the shield conducting film that covers the mold resin.

6. The module as defined in claim 4, wherein the shield conducting wall conducts to the ground because the groove is formed in the mold resin in such a way that it reaches the ground pad on the circuit board.

7. The module as defined in claim 4, wherein the conductive paste or paint has a viscosity suitable for its complete filling into the groove.

8. The module as defined in claim 1, wherein the shield conducting wall is formed by filling a conductive paste or paint into a plurality of non-through holes formed in the mold resin along the boundary that separates the mold resin.

9. The module as defined in claim 8, wherein the non-through hole is so formed as to reach the ground pad on the circuit board.

10. A portable terminal, comprising
a module;
the module including
a circuit board,
electronic components mounted on the circuit board, a mold resin that insulates and seals the electronic components,
a shield conducting film that covers the outside of the mold resin, and
shield conducting walls which are so formed in the mold resin as to divide the mold resin into a plurality of regions.
